# EUROPÄISCHE PATENTANMELDUNG

(11) **EP 1 302 982 A1**
(43) Veröffentlichungstag der Anmeldung: **16.04.2003**
(21) Anmeldenummer: 01124541.2
(22) Anmeldetag: 12.10.2001
(51) Int. Cl.: H01L 21/8242

(54) **Verfahren zum Ausbilden einer vertikalen Feldeffekttransistoreinrichtung**

(71) Anmelder: Infineon Technologies AG, 81669 München (DE)
(72) Erfinder: Birner, Albert, Dr., 01129 Dresden (DE); Goldbach, Matthias, Dr., 01099 Dresden (DE)
(74) Vertreter: Müller - Hoffmann & Partner

(57) **Zusammenfassung**

Es wird vorgeschlagen, beim Ausbilden von Feldeffekttransistoreinrichtungen in Halbleitersubstraten-Überlappungsgebiet eines vorzusehenden Source-Draingebiets (SD) direkt als materielle Bereiche auszubilden, wobei insbesondere Ausdiffusionsvorgänge weitestgehend vermieden werden. Insbesondere geschieht dies durch Ausbilden des Anschlussgebiets (BS) oder Buried-Strap-Gebiets (BS) als selektiv epitaktisch aufgewachsenes einkristallines, gegebenenfalls dotiertes Silizium.

## Beschreibung

Die Erfindung betrifft ein Verfahren zum Ausbilden einer Feldeffekttransistoreinrichtung gemäß dem Oberbegriff von Anspruch 1.

Bei vielen Halbleiterschaltungsanordnungen müssen in einem Halbleitersubstrat entsprechende Feldeffekttransistoreinrichtungen zur Ausbildung und Verschaltung der zugrundeliegenden Halbleiterschaltungsanordnung vorgesehen werden. Insbesondere dienen derartige Feldeffekttransistoreinrichtungen zum Anschließen an ein Leitfähigkeitsgebiet, z. B. ein Bitleitungsanschluss ein Elektrodenanschluss oder dergleichen, des Halbleitersubstrats, wobei ein entsprechendes Anschlussgebiet, z. B. ein Buried-Strap-Bereich zum Anschluss des Source-Drainbereichs des Transistors an eine Topelektrode eines Speicherkondensators, zu einem auszubildenden Source-Draingebiet der Feldeffekttransistoreinrichtung vorgesehen wird. Es wird des Weiteren ein räumliches Überlappungsgebiet des Source-Draingebiets der Feldeffekttransistoreinrichtung mit einem auszubildenden Gateisolationsbereich vorgesehen, um im Betrieb eine Source-Drainkanalstrecke der Feldeffekttransistoreinrichtung ausbilden zu können.

Üblicherweise werden die entsprechenden Anschlussgebiete und/oder die Überlappungsgebiete mit dem Gateisolationsbereich als sogenannte Diffusionsgebiete oder Diffusionskontakte ausgebildet, wobei von einem als Dotierstoffdepot vorgesehenen materiellen Bereich thermisch angeregt entsprechendes Dotierstoffmaterial und mithin Ladungsträger im Halbleitersubstrat mit unterschiedlicher Konzentration verteilt werden.

Problematisch ist dabei, dass die zugrundeliegenden Diffusionsprozesse zum Ausbilden der Ladungsträgerverteilungen in einem gegebenen Materialbereich im Wesentlichen isotrop ablaufen. Ist eine vertikale Ausbreitungsrichtung zum Beispiel zum Kontaktieren mit vertikalen Transistoreinrichtungen bevorzugt, bedeutet das, dass dennoch auch eine laterale Diffusion der Ladungsträger erfolgt, so dass unter Umständen Gegenmaßnahmen zum Vermeiden unerwünschter Kontaktierungen getroffen werden müssen. Bisher wurden diese Gegenmaßnahmen durch eine größere Beabstandung voneinander zu isolierender Leitfähigkeitsbereiche oder Bauelemente realisiert. Aufgrund dieser Notwendigkeit des Einhaltens von minimalen Abständen sind der Zielsetzung einer möglichst hohen Bauteilintegration auf engstem Raum Grenzen gesetzt.

Der Erfindung liegt die Aufgabe zugrunde, ein Verfahren zum Ausbilden einer vertikalen Feldeffekttransistoreinrichtung in einem Halbleitersubstrat anzugeben, bei welchem unerwünschte Kontaktierungen benachbarter Bauelemente hochintegrierter Schaltkreise auf einfache Art und Weise verhindert werden können.

Die Aufgabe wird verfahrensmäßig bei einem gattungsgemäßen Verfahren zum Ausbilden einer Feldeffekttransistoreinrichtung in einem Halbleitersubstrat der eingangs erwähnten Art erfindungsgemäß mit den kennzeichnenden Merkmalen des Anspruchs 1 gelöst. Vorteilhafte Weiterbildungen des erfindungsgemäßen Verfahrens sind Gegenstand der abhängigen Unteransprüche.

Das erfindungsgemäße Verfahren zum Ausbilden einer Feldeffekttransistoreinrichtung in einem Halbleitersubstrat ist dadurch gekennzeichnet, dass das jeweilige Überlappungsgebiet, insbesondere des Source-Draingebiets, der Feldeffekttransistoreinrichtung direkt als materieller Bereich ausgebildet wird, insbesondere unter weitestgehender Vermeidung von lateralen Ausdiffusionsvorgängen.

Es ist somit eine grundlegende Idee der vorliegenden Erfindung, das Überlappungsgebiet des Anschlussgebietes und/oder des Source-Draingebietes in direkter Weise materiell auszubilden und/oder abzuscheiden. Dies geschieht im Gegensatz zu herkömmlichen Vorgehensweisen, bei welchen zunächst ein Überlappungsgebiet in elektrisch isolierender Art und Weise ausgebildet wird, wobei dann im Nachhinein die elektrische Kontaktierung indirekt erfolgt, nämlich durch Ausdiffusion entsprechenden Dotierstoffmaterials und damit durch nachträgliches Einbringen und Verteilen entsprechender Ladungsträger in das an sich elektrisch isolierende Halbleitergebiet. Bei der direkten materiellen und elektrisch leitenden Kontaktierung des Gateisolationsbereichs oder Gateoxidbereichs mit dem Anschlussgebiet, dem Buried-Strap-Gebiet, bzw. dem Source-Draingebiet der Feldeffekttransistoreinrichtung entfällt die Notwendigkeit der nachträglichen Verteilung von Ladungsträgern durch Ausdiffusion, weil direkt ein elektrisch leitfähiges materielles Gebiet oder ein entsprechender Bereich zur elektrischen Kontaktierung des Gateisolierungsbereichs mit den übrigen Gebieten vorgesehen wird.

Bei einer besonders bevorzugten Ausführungsform des erfindungsgemäßen Verfahrens werden das Anschlussgebiet und das Überlappungsgebiet im Wesentlichen aus demselben Material ausgebildet.

Ferner wird bevorzugt, dass das Anschlussgebiet und das Überlappungsgebiet im Wesentlichen einteilig oder einstückig ausgebildet werden, wodurch sich die Prozessabfolgen besonders einfach gestalten lassen und wobei dann Schwierigkeiten im Hinblick auf die Materialkompatibilität vermieden werden.

Gemäß einer weiteren bevorzugten Ausführungsform des erfindungsgemäßen Verfahrens ist es vorgesehen, dass das Anschlussgebiet und/oder das Überlappungsgebiet epitaktisch aufgewachsen und/oder einkristallin ausgebildet werden, insbesondere als selektiv epitaktisch einkristallin dotiertes Silizium oder dergleichen.

Gemäß einer weiteren Ausführungsform des erfindungsgemäßen Verfahrens ist es vorgesehen, dass zum Vermeiden oder Unterdrücken von Ausdiffusionsvorgängen aus dem Anschlussgebiet und/oder dem Überlappungsgebiet und/oder zum Vermeiden oder Unterdrücken von nicht gewünschten elektrischen Kontakten des Anschlussgebietes und/oder des Überlappungsgebietes mit weiteren Gebieten das Anschlussgebiet und/oder das Überlappungsgebiet zumindest teilweise in ein Isolationsgebiet eingeschlossen werden.

Besonders vorteilhaft ist es, wenn das Anschlussgebiet und/oder das Überlappungsgebiet als Buried-Strap-Struktur, als Buried-Strap-Gebiet und/oder als Teil davon ausgebildet werden, insbesondere in im Wesentlichen vergrabener Form.

Gemäß einer weiteren Ausführungsform des erfindungsgemäßen Verfahrens wird die jeweilige Feldeffekttransistoreinrichtung als vertikale Grabenstrukturtransistoreinrichtung, insbesondere als Deep-Trench-Transistor oder dergleichen und/oder insbesondere zum Anschließen an und/oder für eine DRAM-Speicherzelle oder dergleichen ausgebildet.

Dazu wird im Halbleitersubstrat jeweils eine Ausnehmung oder ein Graben ausgebildet.

In einem oberen Grabenabschnitt mit oberen Randbereichen oder oberen Wandbereichen wird die vertikale Grabenstrukturtransistoreinrichtung mit einem gegenüber den oberen Randbereichen oder oberen Wandbereichen und gegenüber einem vorzusehenden mittleren Grabenabschnitt im Gatebereich im Wesentlichen elektrisch isoliert ausgebildet.

Es ist ferner vorgesehen, dass im Wesentlichen unmittelbar räumlich anschließend an den isolierten Gatebereich, insbesondere räumlich unterhalb davon, der Source-Drain-Bereich sowie das Anschlussgebiet im Bereich des mittleren Grabenabschnitts vorgesehen und ausgebildet werden.

Des Weiteren ist es vorgesehen, dass in im Wesentlichen elektrisch leitendem Kontakt zumindest mit dem Anschlussgebiet das zu kontaktierende erste Leitfähigkeitsgebiet im Wesentlichen in einem unteren Grabenabschnitt vorgesehen und ausgebildet wird.

Gemäß einer besonders bevorzugten Ausführungsform des erfindungsgemäßen Verfahrens ist es vorgesehen, dass zunächst ein Maskenbereich auf einem Oberflächenbereich, der im Wesentlichen planar ausgebildet sein kann, das Halbleitersubstrat, gegebenenfalls mehrschichtig ausgebildet, abgeschieden und gemäß einer gewünschten auszubildenden Grabenstruktur mit Ausnehmungen strukturiert wird.

Des Weiteren ist es vorgesehen, dass als Halbleitersubstrat ein einkristallines Halbleitermaterial verwendet wird, insbesondere einkristallines Silizium, gegebenenfalls p-dotiert, und/oder dergleichen.

Besonders vorteilhaft für das erfindungsgemäße Verfahren ist es, dass gegebenenfalls die jeweilige Ausnehmung und/oder der jeweilige Graben in mehreren zeitlich voneinander getrennten und/oder unterbrochenen Prozessschritten strukturiert werden, so dass zwischenzeitlich andere Strukturierungsprozesse in vorteilhafter Weise eingefügt werden können.

Dabei ist es vorgesehen, dass zunächst der obere Grabenabschnitt mit oberen Randbereichen oder Wandbereichen in das Halbleitersubstrat geätzt wird, insbesondere mit einer Tiefe im Bereich von 1 µm, insbesondere für die vertikale Grabenstrukturtransistoreinrichtung, wobei ein erster temporärer Bodenbereich in der Ausnehmung oder im Graben ausgebildet wird.

Der obere Grabenabschnitt wird, insbesondere lateral, aufgeweitet, vorzugsweise durch einen im Wesentlichen isotropen Rückätzschritt und/oder insbesondere durch ein Silizium-Pull-Back-Verfahren, vorzugsweise im Bereich einer Schichtdicke von ca. 5 nm.

Es wird eine erste Schutzschicht oder Isolationsschicht abgeschieden, insbesondere in konformaler Art und Weise und/oder insbesondere mit einer Schichtdicke im Bereich von ca. 5 nm, vorzugsweise als Si₃N₄-Liner oder dergleichen.

Es wird dann ferner durch, insbesondere anisotropes, Ätzen unter Durchbrechung der ersten Schutzschicht am ersten temporären Bodenbereich der Ausnehmung oder Grabens der zweite, mittlere Grabenabschnitt mit mittleren Wandbereichen oder Randbereichen, insbesondere für den Anschlussbereich, für den Source-Drain-Bereich und/oder für den Überlappungsbereich oder für Teile davon ausgebildet, vorzugsweise mit einer Tiefe im Bereich von ca. 200 - 300 nm, wobei ein zweiter temporärer Bodenbereich in der Ausnehmung bzw. im Graben ausgebildet wird.

Der mittlere Grabenabschnitt wird, insbesondere lateral, aufgeweitet, und zwar vorzugsweise durch einen isotropen Rückätzschritt und/oder insbesondere durch ein Silizium-Pull-Back-Verfahren, vorzugsweise im Bereich einer Schichtdicke von ca. 20 bis 40 nm, wobei dadurch Ausnehmungen im Bereich der mittleren Seitenwände, Randbereiche oder Wandbereiche des mittleren Grabenabschnitts, insbesondere für den vorzusehenden Anschlussbereich, Source-Drain-Bereich und/oder Überlappungsbereich oder Teile davon geschaffen werden.

Zum Ausbilden des Isolationsgebiets für das Anschlussgebiet, das Source-Draingebiet und/oder das Überlappungsgebiet und/oder für Teile davon, wird eine zweite Schutzschicht oder Isolationsschicht ausgebildet, insbesondere in konformaler Art und Weise, mit einer Schichtdicke im Bereich von ca. 10 nm und/oder insbesondere unter Verwendung von Siliziumdioxid SiO₂, oxidiertem Siliziumnitrid Si₃N₄ und/oder dergleichen.

Ferner ist es zum Ausbilden des Anschlussgebiets, des Source-Draingebiets und/oder des Überlappungsgebiets und/oder von Teilen davon, vorgesehen, dass ein einkristalliner Keimbereich ausgebildet wird, insbesondere zum Ausbilden der zuerst genannten Gebiete als selektive, einkristallin epitaktisch aufgewachsene Halbleitermaterialbereiche.

Der einkristalline Keimbereich wird ausgebildet durch, insbesondere anisotropes, Ätzen unter Durchbrechung der zweiten Schutzschicht oder Isolationsschicht am zweiten temporären Bodenbereich des zweiten oder mittleren Grabenabschnitts, wobei am zweiten temporären Bodenbereich zugrundeliegendes einkristallines Halbleitersubstrat freigelegt wird, wobei gegebenenfalls weiter der zweite temporäre Bodenbereich durch Ätzen im Sinne eines Overetch-Prozesses leicht ausgenommen wird. Zur Ausbildung des Buried-Strap im Sinne eines Anschlussgebiets, Source-Draingebiets und/oder Überlappungsgebiet oder für Teile davon ist es vorgesehen, dass auf dem einkristallinen Keimbereich selektiv epitaktisch einkristallines Halbleitersubstrat derart aufgewachsen wird, dass der mittlere Grabenabschnitt vollständig gefüllt wird, insbesondere bis leicht über das Niveau des ersten temporären Bodenbereichs der Ausnehmung oder des Grabens hinaus, wobei gegebenenfalls eine variierende Dotierstoffkonzentration eingebracht wird, insbesondere in Form eines Konzentrationsgradienten, und/oder wobei insbesondere die seitlichen Ausnehmungen im Bereich des zweiten, mittleren Grabenabschnitts für das Buried-Strap-Gebiet als Anschlussgebiet, Source-Draingebiet und/oder Überlappungsgebiet und/oder Teile davon im Bereich der mittleren Bandbereiche oder Randbereiche vollständig gefüllt werden.

Der mittlere Grabenabschnitt, welcher durch das epitaktische Aufwachsen und Verfüllen geschlossen wurde, wird wieder geöffnet und zwar leicht unterhalb des Niveaus des zweiten temporären Bodenbereichs hinaus, insbesondere durch anisotropes Ätzen, wobei insbesondere Material der zweiten Schutzschicht oder Isolationsschicht im Bereich der oberen Randbereiche oder Wandbereiche entfernt wird.

Es wird eine dritte Schutzschicht oder Isolationsschicht ausgebildet, so dass der zweite temporäre Bodenbereich und im Bereich der mittleren Wandbereiche oder Randbereiche des mittleren Grabenabschnitts der Ausnehmung oder des Grabens das selektiv epitaktisch aufgewachsene einkristalline Material in den Ausnehmungen für das Buried-Strap-Gebiet, nämlich für das Anschlussgebiet, das Source-Draingebiet und/oder das Überlappungsgebiet oder für Teile davon, abgedeckt wird.

Vorzugsweise erfolgt das Ausbilden der dritten Schutzschicht oder Isolationsschicht durch thermische Oxidation. Denkbar ist auch ein selektives elektrochemisches Abscheiden und/oder Umwandeln, insbesondere durch Oxidation des Siliziummaterials.

Nachfolgend wird dann durch, insbesondere anisotropes, Ätzen der dritte oder untere Grabenabschnitt der Ausnehmung oder des Grabens ausgebildet. Nachfolgend kann dann z. B. ein Trenchkondensator im Bereich der unteren Grabenabschnitts ausgebildet werden. Dies erfolgt z. B. durch Ausbilden einer Buried-Plate-Struktur als Bottomelektrode, anschließendem Verfüllen mit einem Nodedielektrikum und nachfolgendem Einbringen einer Topelektrode. Dann wird das erste Leitfähigkeitsgebiet, z. B. als Teil der Topelektrode oder als Anschluss dafür, in diesem dritten oder unteren Grabenabschnitt angelegt, vorzugsweise bis zu einem Niveau unterhalb des ersten temporären Bodenbereichs, vorzugsweise durch Füllen des Grabens mit Polysilizium oder dergleichen und entsprechendes anisotropes Rückätzen auf das gewünschte Niveau, wobei gegebenenfalls eine vierte Schutzschicht oder Isolationsschicht zwischen dem Halbleitersubstrat und dem Material des ersten Leitfähigkeitsgebiets vorgesehen wird.

Das Material des dritten Schutzbereichs oder Isolationsbereichs wird selektiv, insbesondere in dem das selektiv epitaktisch aufgewachsene einkristalline Material in den Ausnehmungen für das Buried-Strap-Gebiet abdeckenden Bereich davon entfernt, insbesondere durch selektives, nasschemisches Ätzen.

Dadurch entsteht eine entsprechende Lücke oder Beabstandung zwischen dem Material des ersten Leitfähigkeitsgebiets und dem epitaktisch selektiv aufgewachsenen einkristallinen Materials für den Buried-Strap-Bereich. Das erste Leitfähigkeitsgebiet wird mit dem Anschlussgebiet oder dem Buried-Strap-Gebiet elektrisch kontaktiert, insbesondere durch Auffüllen der entsprechenden Lücken mit Polysilizium und/oder durch selektives epitaktisches Nachwachsen und Verschließen der Lücken zwischen dem ersten Leitfähigkeitsgebiet und dem Material des Anschlussgebiets bzw. des Buried-Strap-Bereichs, wobei zumindest ein Teil der mittleren Wandbereiche oder Randbereiche des mittleren oder zweiten Grabenabschnitts des Grabens oder der Ausnehmung, also insbesondere des Anschlussgebiets, frei und unbedeckt verbleiben.

Es wird dann der Oberflächenbereich des ersten Leitfähigkeitsgebiets mit einer fünften Schutzschicht oder Isolationsschicht, insbesondere aus Siliziumdioxid Si₂O₃, abgedeckt, wobei wiederum ein Teil der mittleren Wandbereiche oder Randbereiche des mittleren Grabenabschnitts des Grabens oder der Ausnehmung, also des Anschlussgebiets frei und unbedeckt verbleiben. Diese fünfte Schutzschicht oder Isolationsschicht auf dem Oberflächenbereich des ersten Leitfähigkeitsgebiets dient klassischerweise als sogenanntes Trench-Top-Oxid TTO.

Es ist ferner vorgesehen, dass durch, insbesondere isotropes, Ätzen zumindest im Bereich des Übergangs zwischen dem mittleren Grabenabschnitt und dem oberen Grabenabschnitt und insbesondere in den Ausnehmungen für das Buried-Strap-Gebiet, nämlich in den Ausnehmungen für das Anschlussgebiet, das Source-Draingebiet, das Überlappungsgebiet und/oder für Teile davon, jeweils vorhandene Isolationsschichten oder Schutzschichten zwischen dem Buried-Strap-Gebiet und dem Halbleitersubstrat entfernt werden, wobei insbesondere eine sich im Wesentlichen lateral erstreckende Ausnehmung geschaffen wird im oberen Bereich des Buried-Strap-Gebiets oder Anschlussgebietes.

Es muss ein materieller elektrischer Kontakt zwischen dem verbleibenden Buried-Strap-Gebiet oder Anschlussgebiet und dem oberhalb davon vorgesehenen Halbleitersubstrat durch Füllen der Ausnehmung im oberen Bereich des Anschlussgebiets mit einem elektrisch leitfähigen Material ausgebildet werden.

Dabei kann das Füllen durch selektives epitaktisches Aufwachsen oder Nachwachsen oder im Rahmen eines Wasserstoff-Reflow-Prozesses erfolgen.

Nach Herstellung dieser Auffüllung bildet der aufgefüllte Bereich im Wesentlichen das vorzusehende Überlappungsgebiet in bezug auf den vorzusehenden und zu isolierenden Gatebereich.

Dazu wird zur Ausbildung des Gatebereichs der Grabenstrukturtransistoreinrichtung zunächst eine sechste Isolationsschicht als Gateisolationsbereich abgeschieden, insbesondere in Form eines Oxids oder dergleichen und/oder insbesondere an den freigebliebenen Bereichen der oberen und/oder mittleren Randbereiche oder Wandbereiche des mittleren und oberen Grabenabschnitts des Grabens. Dabei wird das freigebliebene Volumen des Grabens oder der Ausnehmung mit einem zweiten Leitfähigkeitsgebiet als Gatekontakt aufgefüllt.

Diese und weitere Aspekte der vorliegenden Erfindung ergeben sich aus den nachstehenden Bemerkungen:

Die Erfindung beschreibt einen Integrationsablauf, der eine DRAM-Zelle realisiert, die vollständig in einen Deep Trench ausgebildet ist,
- mit selbstjustierendem Epi-Buried-Strap und
- ohne Buried-Strap-Ausdifussion und für den Anschluss an das Source-Draingebiet des VFET, wobei
- lateral die thermisch bedingte BS-Ausdiffusion durch Dielektrikum-Shield und (optional) Dotierungsgradient in der Epi-Schicht unterdrückt wird.

Die Erfindung basiert auf dem Konzept "CFE", des vergrabenen Collarbereichs und integriert in dieses Konzept bzw. in vergleichbare DT-Konzepte für vertikale DRAM-Zellen einen Epitaxie-basierten Buried Strap oder Anschlussbereich.

Bisherige Standardkonzepte (CCT, BPC) sehen eine sequentielle Herstellung von DT, Buried Plate, Node Dielektrikum, Poly Fill, Collar und Buried Strap in verschiedenen Abfolgen vor. Dabei wird beim CCT-Konzept die Abfolge wie eben beschrieben verwendet. Bei BPC-Konzept erfolgt die Collar-Bildung zwischen DT-Etch und Buried Plate Formierung durch Verwendung unter anderem einer Dummyfüllung aus Polysilizium.

Ein sich davon abgrenzendes, innovatives und sehr gut skalierbares Konzept mit vergrabenem Collar (CFE) integriert die Collar-Realisierung in den DT-Etch, welcher zweimal unterbrochen wird, um die Oberkante und die Unterkante des Collars zu definieren.

Der zentrale Punkt der Ausbildung eines Buried Straps wurde bislang ausschließlich durch Ausdiffusion aus einer hochdotierten Polyfüllung durch ein SiN-Interface, unterstützt durch einen Implantationsschritt, gelöst. Der (Buried) Strap ist das kritischste Element einer DRAM-Zelle. Nachstehend wird ein solcher beschrieben, wie er für vertikale Trench Konzepte (VT-Cells) besonders vorteilhaft Anwendung finden könnte.

Die Erfindung löst das gegebene Problem dadurch, dass ein auf Epitaxie basierter Buried Strap (BS) in die DT-Seitenwand integriert wird. Dieser BS sitzt auf einer Diffusionsbarriere. Obere und untere Begrenzung des BS wird durch Unterbrechungen beim DT-Etch definiert. Dabei gehen Anschlussgebiet (Buried Strap) und Drain des Auswahltransistors ineinander über und können dementsprechend nicht mehr geometrisch voneinander getrennt werden.

Als zusätzliche Vereinfachungen ergeben sich:
- Unterdrückung der lateralen Ausdiffusion aus dem BS-Gebiet bei niedriger Ausbildung der Diffusionsbarriere (Barrierenhöhe ∼ 100 - 200 nm),
- vollständige Unterdrückung der lateralen Ausdiffusion und Realisierung flacher VFET-Junctions bei hoher Ausbildung der Diffusionsbarriere(Höhe » 200 nm); dabei wird auch die Gefahr von Punch-Throughs verringert, da VFET teilweise oder ganz von einer Dielektrikum-Hülle (bevorzugt SiO₂) umgeben ist; SOI-ähnliches Verhalten des VFET,
- Verringerung des BS-Gesamtwiderstandes durch Bildung einer großen Überlappfläche zwischen DT Fill und hochdotiertem BS-Gebiet; dadurch: unkritischer Überlapp zwischen DT-Fill-Oberkante und BS-Gebiet,
- Vereinfachung des Collars und
- Drain-Gebiet des Transistors definiert durch Epi-Gebiet des Buried Strap; durch Wahlfreiheit bei der Dotierstoffkonzentration bzw. des Dotierstoffgradienten in der Epi-Schicht: geringer Übergangswiderstand BS > Drain möglich.

Ein erfinderischer Schritt liegt im Vergraben des Buried Strap Gebietes in die DT-Seitenwand durch eine Pull-Back-Methode und nachfolgendes selektiv-epitaktisches Verfüllen der BS-Region mit hochdotiertem n-Polysilizium. Dieses einkristalline epitaktische Wachstum ist möglich in Konzepten, in denen der DT-Etch unterbrochen wird, so dass am Boden noch einkristallines Silizium vorhanden ist. Dabei werden die Ober- und Unterkanten des BS-Gebietes durch Unterbrechung der DT-Ätzung definiert.

Nach der Ätzung eines kurzen DT wird eine Schutzschicht abgeschieden, welche die bestehende DT-Seitenwand vor dem späteren Pull-Back-Schritt schützt. Diese Schicht kann z.B. ein Nitrid sein. Auch ein "ONO" oder ein "NO" würden diesen Zweck erfüllen. Um diese Schutzschicht vor den nachfolgenden RIE-Schritten zu schützen, kann es vorteilhaft sein, den DT vor der Abscheidung dieser Schicht etwas aufzuweiten.

Nach dem Silizium-Pull-Back, der das Gebiet, in dem der Buried Strap zu liegen kommen soll, freilegt, wird eine Isolatorschicht abgeschieden, die wiederum aus z.B. SiO₂, Si₃N₄, "NO", "ONO", SiON sein kann. Die Schicht soll eine Ausdiffusion von Dotant aus dem BS in die umgebende p-well verhindern. Durch die Höhe dieser Schicht (entspricht der Höhe des epitaktischen BS-Gebietes) kann die Shield-Funktion feineingestellt werden. Diese Schicht wird anschließend durch einen RIE-Schritt am Boden geöffnet.

Durch einen selektiven Epitaxieschritt wird, vom Boden her beginnend, die Ausnehmung für das gesamte Buried-Strap-Gebiet gefüllt. Hierbei kann ein Dotierstoffgradient verwirklicht werden, um BS, Drain und Kanaleigenschaften feineinzustellen. Als besonderer Extremfall sei hier genannt, dass das Shield sich auch vollständig über den gesamten VFET hochziehen kann, so dass mögliche Junction-Probleme durch den Übergang Epi-Si <-> Si minimiert werden können.

Dann wird der DT fertig ausgebildet, der (buried) Collar gebaut, die Buried Plate eindiffundiert, das Dielektrikum abgeschieden und der DT z.B. mit hochdotiertem Poly-Silizium, z.B. als Top-Elektrode, gefüllt.

Der Anschluss zwischen Trench-Fill und Epi-BS wird durch einen weiteren selektiven Epitaxieschritt (undoped) bzw. durch einen leichten H₂-Reflow ausgeführt.

Es folgt das Einfüllen des Trench-Top-Oxids (TTO), gefolgt vom nasschemischen Öffnen des Shieldes am oberen Rand.

Dann erfolgt der Anschluss des BS/Drain-Gebietes an den Rest des VFET durch einen weiteren, undotierten selektiven Epi-Schritt bzw. einen leichten H₂-Reflow-Schritt. Anschließend kann die Zelle gemäß einem beliebigen VFET-Konzept realisiert werden.

Nachfolgend wird die Erfindung anhand einer schematischen Zeichnung auf der Grundlage einer bevorzugten Ausführungsform des erfindungsgemäßen Verfahrens näher erläutert.

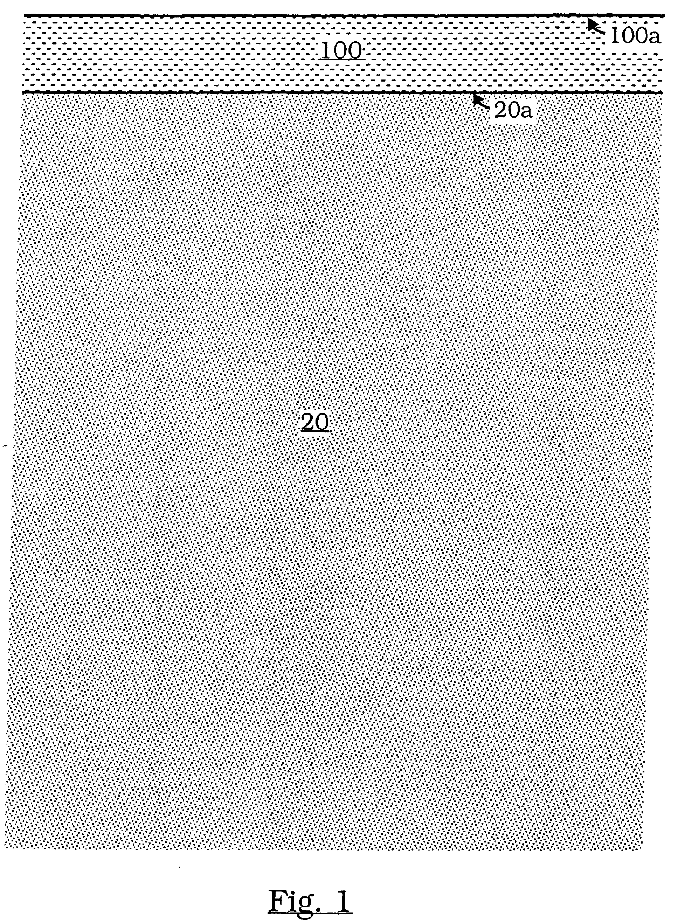

- Fig. 1 - 20: zeigen in schematischer und seitlicher Querschnittsansicht verschiedene Zwischenstufen, die beim Herstellen einer Feldeffekttransistoreinrichtung gemäß einer bevorzugten Ausführungsform des erfindungsgemäßen Verfahrens erreicht werden.

In den nachstehend beschriebenen Figuren beziehen sich identische Bezugszeichen auf dieselben Elemente, ihre Detailbeschreibung wird nicht in jedem Fall wiederholt.

Ausgangspunkt des im folgenden beschriebenen Ausführungsbeispiels für das erfindungsgemäße Herstellungsverfahren ist die in Fig. 1 gezeigte Anordnung, bei welcher auf einem Halbleitersubstrat 20, z.B. einem einkristallinen p-dotierten Bulk-Siliziumbereich, mit planarem Oberflächenbereich 20a eine Ätzmaskenschicht 100 mit planarem Oberflächenbereich 100a vorgesehen ist.

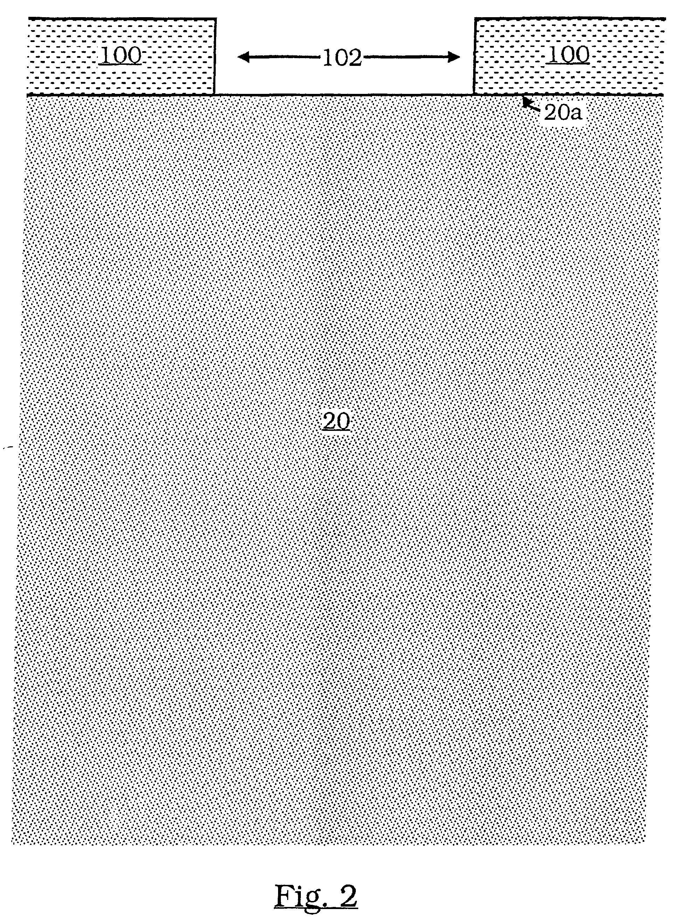

Im Übergang zu dem in Fig. 2 gezeigten Zwischenzustand werden dann in der Ätzmaskenschicht 100 an vordefinierten Stellen Ausnehmungen 102 gebildet, welche bis auf den Oberflächenbereich 20a des zugrundeliegenden Halbleitersubstrats 20 reichen. Die Position der jeweiligen Ausnehmungen 102 definieren die Positionen der auszubildenden Grabenstrukturtransistoreinrichtungen.

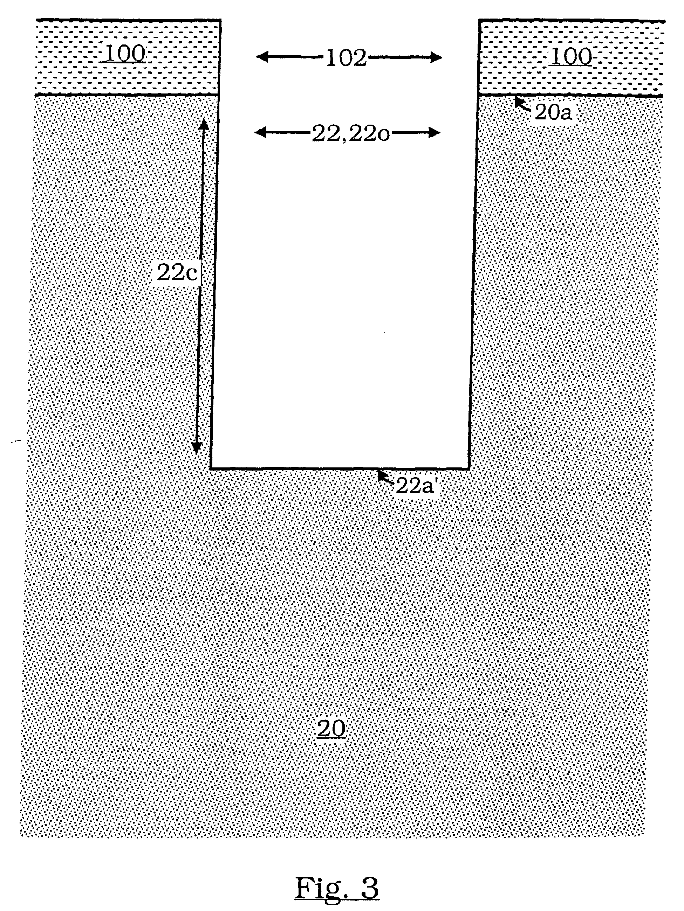

Im Übergang zu dem in Fig. 3 gezeigten Zwischenzustand wird dann durch einen ersten anisotropen Ätzschritt mit einer Tiefe von etwa 1 µm ein erster oder oberer Grabenabschnitt 22o des auszubildenden Grabens 22 in das zugrundeliegende Halbleitersubstrat 20 geätzt. Dieser erste oder obere Grabenabschnitt 220 dient im Wesentlichen der Aufnahme des vertikal ausgerichteten Feldeffekttransistors oder VFET. Er besitzt obere Randbereiche 22c oder Wandbereiche 22c und einen ersten temporären Bodenbereich 22a'.

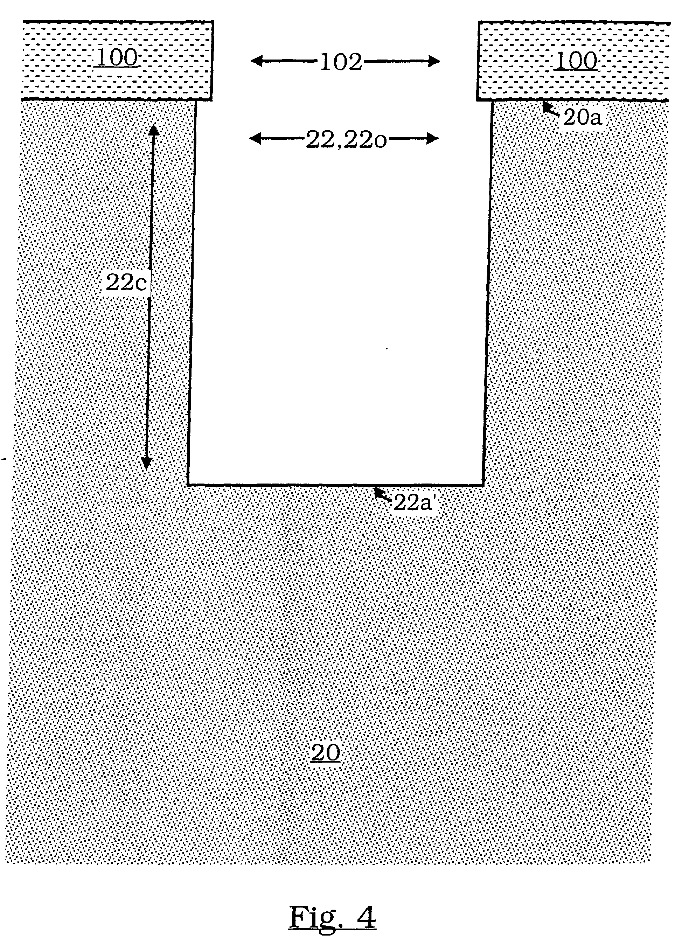

Im Übergang zu dem in Fig. 4 gezeigten Zwischenzustand wird dann zunächst der erste oder obere Grabenabschnitt 22o isotrop durch ein Silizium-Pull-Back-Verfahren um ca. 5 nm aufgeweitet, so dass zurückgezogene obere Randbereiche und Wandbereiche 22c und ein zurückgezogener erster Bodenbereich 22a' entstehen.

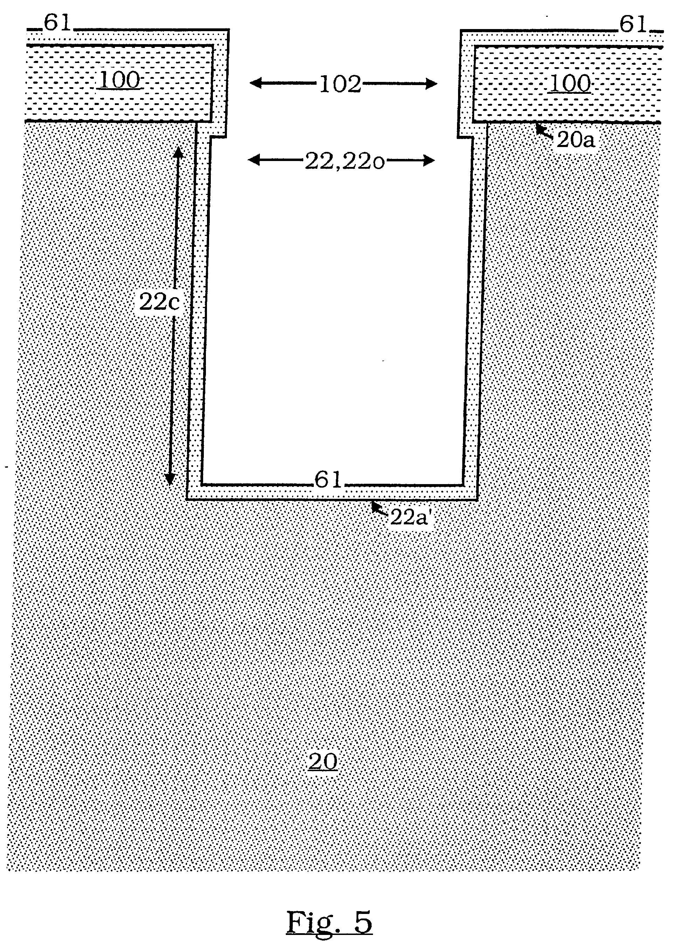

Nachfolgend wird dann mit einer Schichtdicke von zum Beispiel 5 nm eine erste Isolationsschicht 61 oder Schutzschicht 61 in Form eines Siliziumnitridliners konform abgeschieden, wie das in Fig. 5 gezeigt ist.

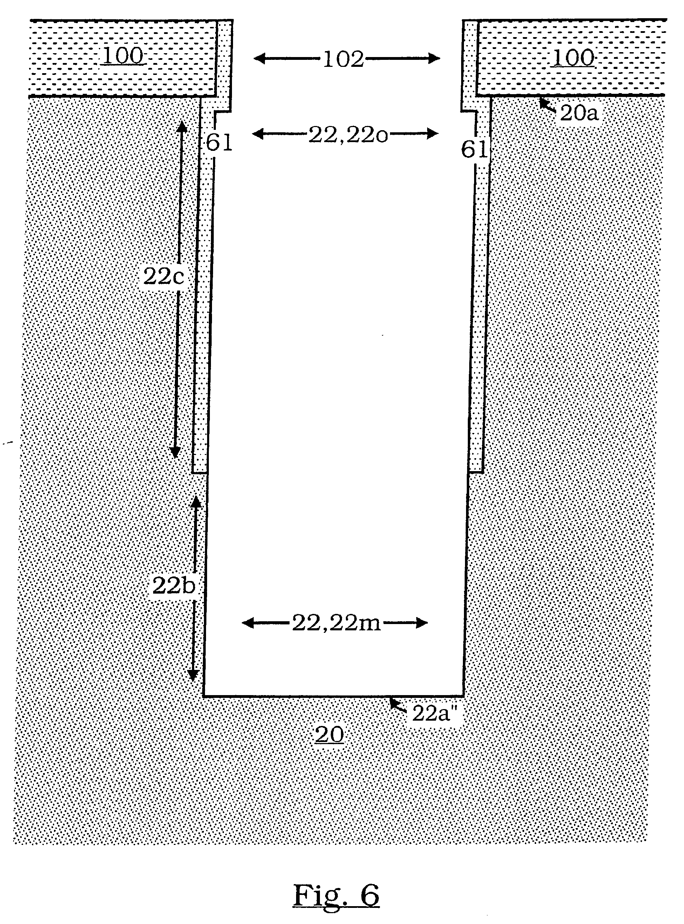

Dann erfolgt in einem weiteren Ätzschritt in anisotroper Art und Weise eine Fortsetzung des Ausbildens der Ausnehmung 22 oder des Grabens 22 durch Durchbruch des Siliziumnitridliners 61 im Bereich des ersten temporären Bodenbereichs 22a', wobei der zweite oder mittlere Grabenabschnitt 22m mit entsprechenden mittleren Wandbereichen oder Randbereichen 22b und einem zweiten temporären Bodenbereich 22a" ausgebildet wird, wie das in Fig. 6 gezeigt ist.

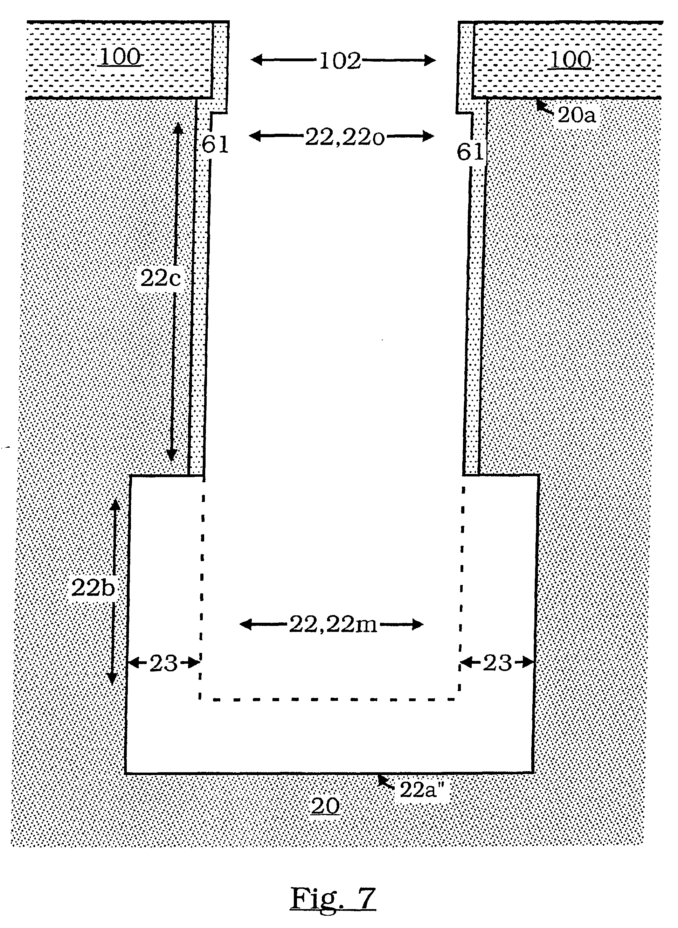

Im Übergang zum Zustand der Fig. 7 wird nun selektiv durch einen isotropen Ätzvorgang das Halbleitermaterial derart rückgeätzt, dass der zweite oder mittlere Grabenabschnitt 22m lokal aufgeweitet wird, wogegen die oberen Randbereiche oder Wandbereiche 22c aufgrund des Siliziumnitridliners 61 davon unbeeinflussst bleiben. Durch den Rückätzvorgang, zum Beispiel mit einer Schichtdicke von 20 bis 40 nm, werden im Bereich des zweiten oder mittleren Grabenabschnitts 22m Ausnehmungen 23 in dem mittleren Wandbereichen oder Randbereichen 22b gebildet, welche der Ausbildung und Aufnahme des sogenannten Buried-Strap-Gebiets dienen, nämlich der Aufnahme des Anschlussgebiets, des Source-Draingebiets, des Überlappungsgebiets und/oder von Teilen davon.

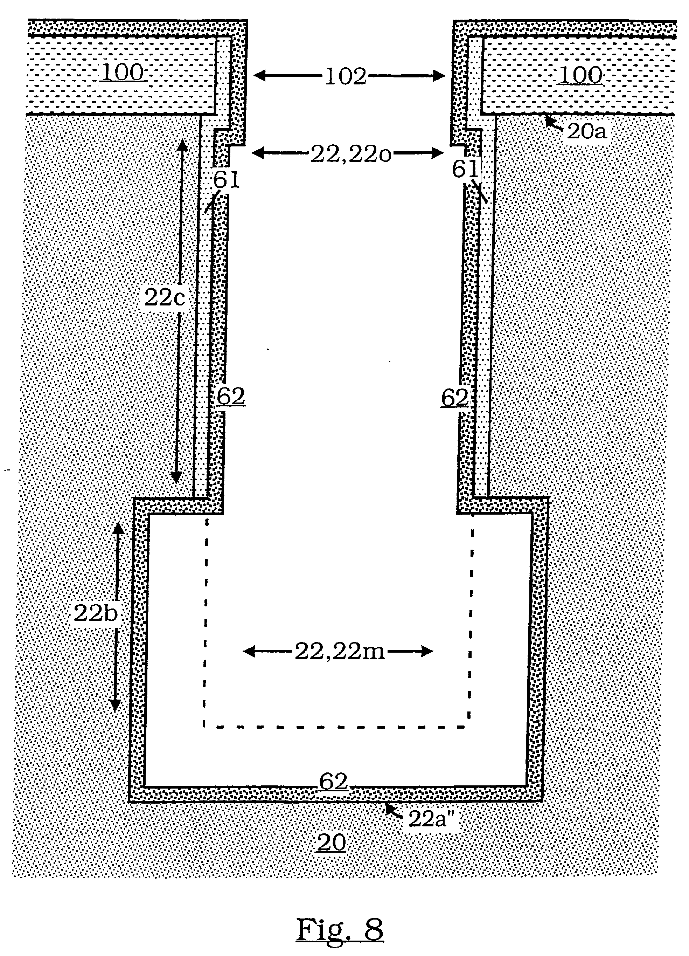

Im Übergang zum Zustand der Fig. 8 wird dann in konformaler Art und Weise eine zweite Isolationsschicht oder Schutzschicht 62 in Form einer Siliziumdioxidschicht konformal abgeschieden.

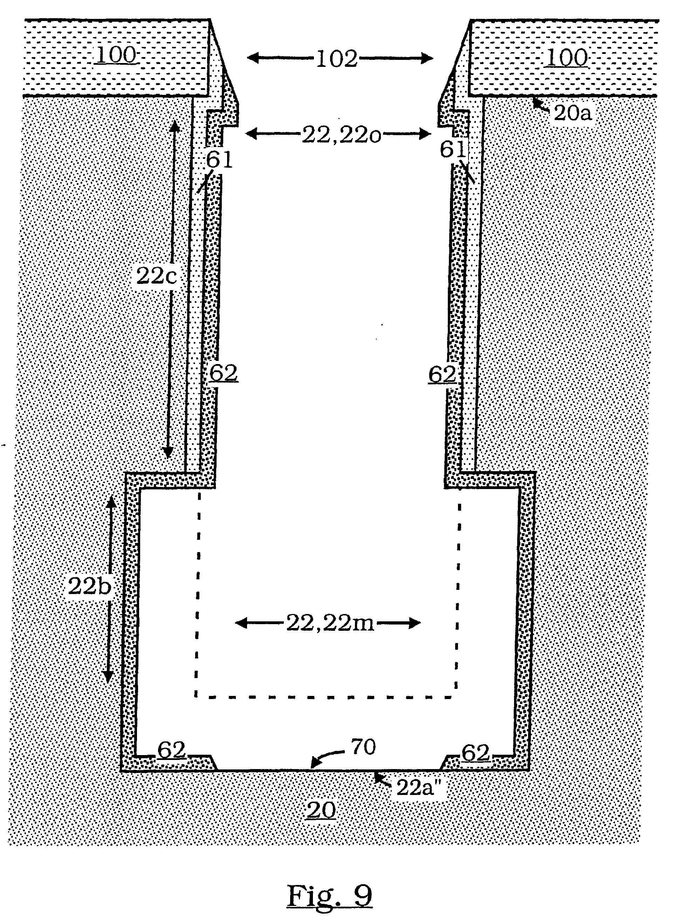

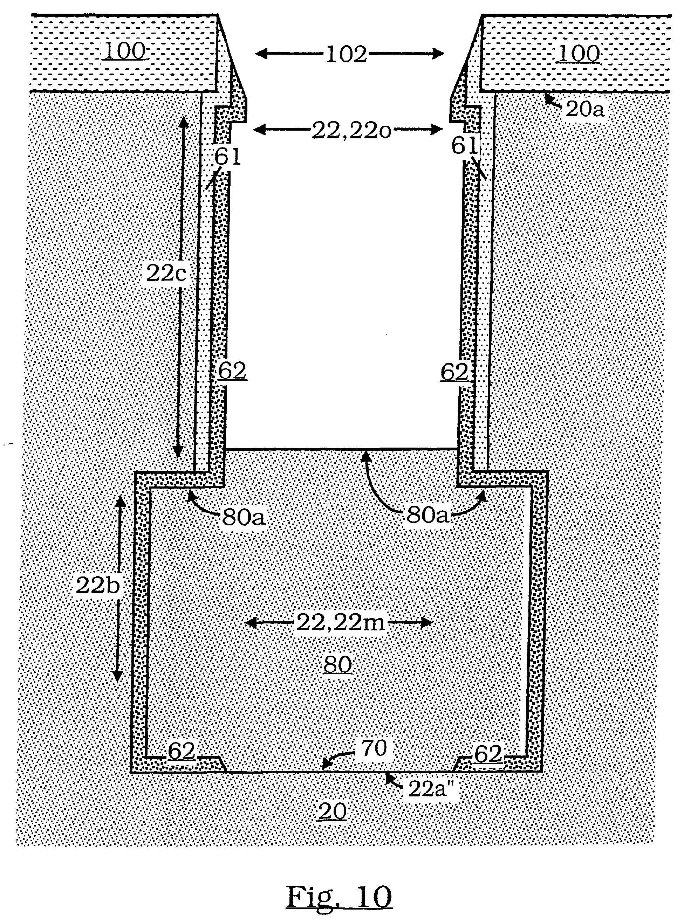

Dann wird, wie in Fig. 9 gezeigt ist, durch anisotropes Ätzen der jeweils freiliegende laterale Anteil der zweiten Isolationsschicht oder Schutzschicht 62 entfernt, so dass insbesondere im Bereich des zweiten temporären Bodenbereichs 22a" das zugrundeliegende einkristalline Halbleitersubstrat 20 durch den Overetchvorgang freigelegt wird. Dieser freigelegte Bereich des einkristallinen Halbleitersubstrats 20 im Bereich des zweiten temporären Bodenbereichs 22a" dient als Keimschicht 70 für das nachfolgend durchzuführende selektive epitaktische Aufwachsen einkristallinen Siliziummaterials 80, dessen Endzustand in Fig. 10 illustriert ist.

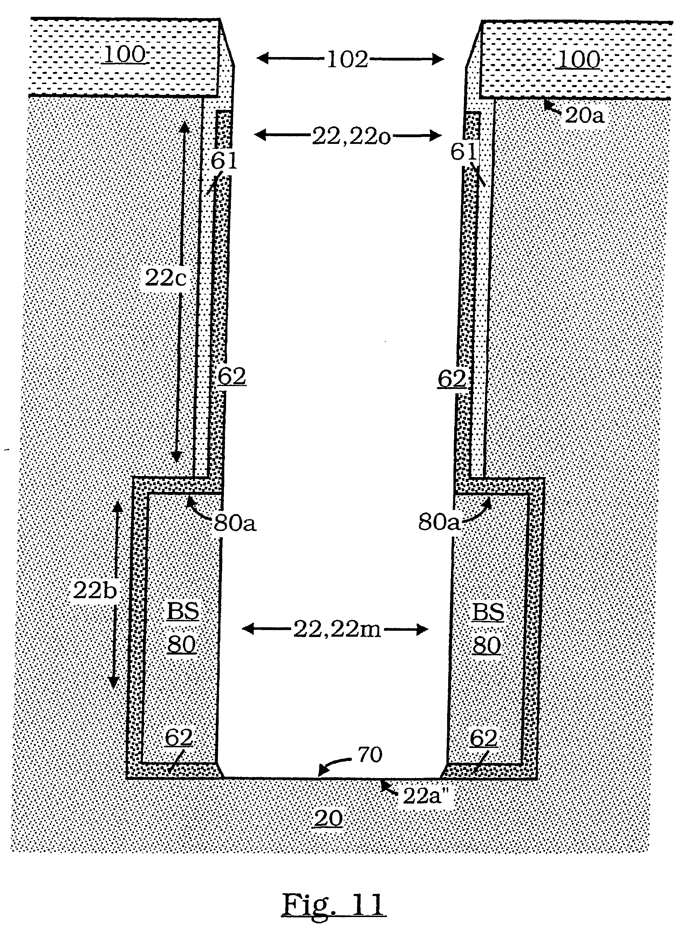

Im Übergang zum Zustand der Fig. 11 wird dann das Ätzen des zweiten Grabenabschnitts 22m in anisotroper Form wiederholt, wobei die abgeschiedene zweite Isolationsschicht oder Schutzschicht 62 von den oberen Wandbereichen oder Randbereichen 22c des ersten oder oberen Grabenabschnitts 22o entfernt werden und wobei das epitaktisch aufgewachsene Material 80 außerhalb der Ausnehmungen 23 bis unterhalb des Niveaus des zweiten temporären Bodenbereichs 22a" entfernt wird.

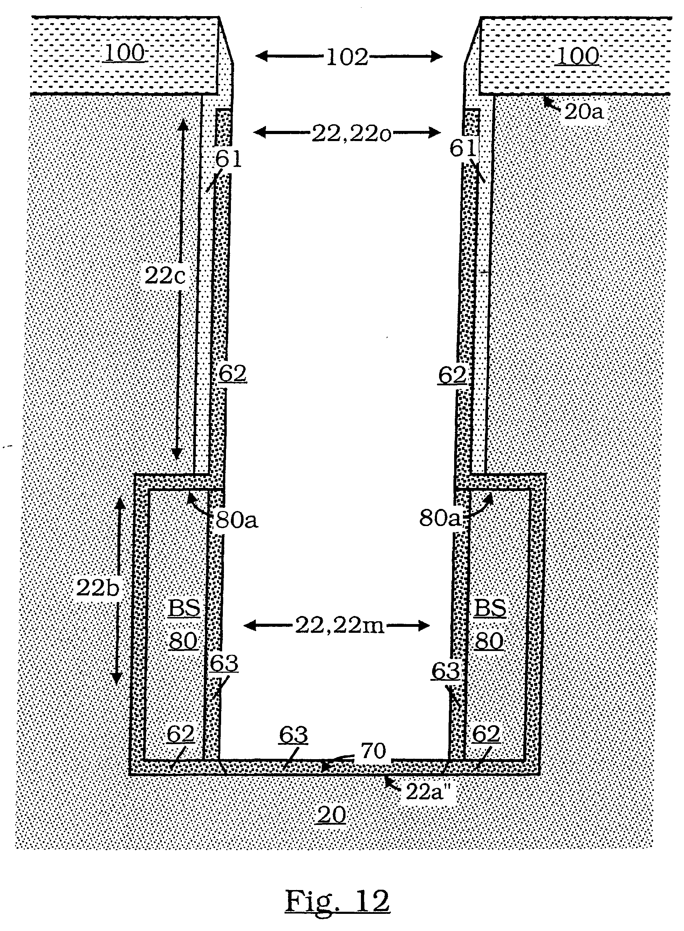

Nachfolgend wird dann eine dritte Isolationsschicht oder Schutzschicht 63 in Form einer Siliziumdioxidschicht ausgebildet, und zwar durch selektives, lokales Oxidieren der freiliegenden Siliziumbereiche 70 und 80, wie das in Fig. 12 gezeigt ist. Dabei werden die freiliegenden Bereiche des epitaktisch aufgewachsenen Materials 80 für das Buried-Strap-Gebiet in den Ausnehmungen 23 von der dritten Isolationsschicht oder Schutzschicht 63 eingebettet und somit geschützt.

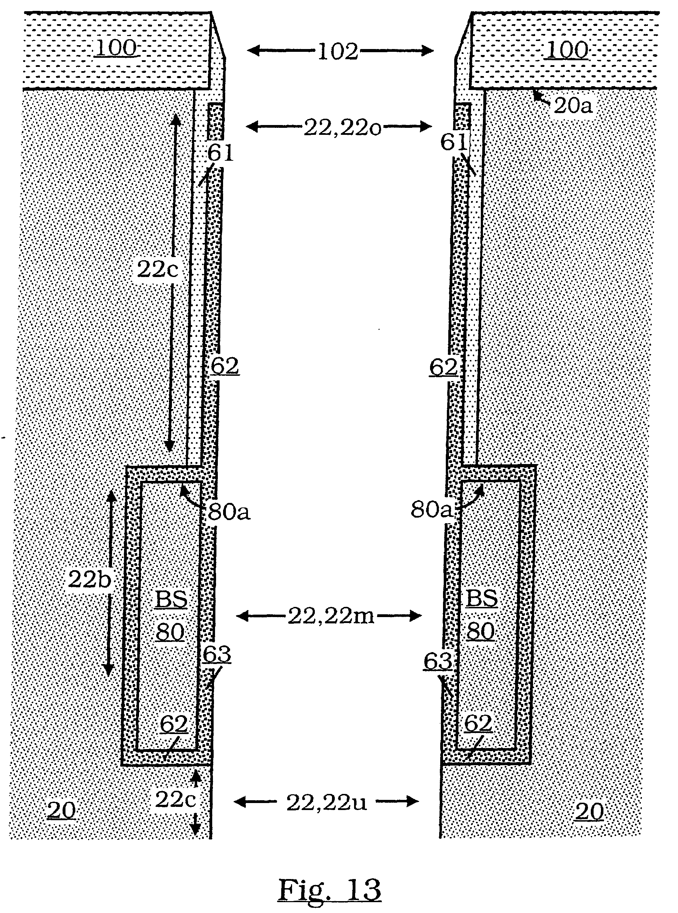

Im Übergang zu dem in Fig. 13 gezeigten Zwischenzustand wird dann durch einen weiteren anisotropen Ätzschritt der dritte oder untere Grabenabschnitt 22u ausgebildet.

In einer nachfolgenden Prozessfolge wird dann der untere Bereich der Schaltungsanordnung im Halbleitersubstrat im unteren Grabenabschnitt 22u ausgebildet. Dabei kann es sich zum Beispiel um das Ausbilden eines vertikalen Speicherkondensators mit einem Node-Dielektrikum handeln. Schließlich wird das sogenannte erste Leitfähigkeitsgebiet 30 durch eine Polysiliziumfüllung mit einem Rückätzprozess bis unterhalb des ersten temporären Bodenbereichs 22a' ausgeführt, wobei gegebenenfalls eine vierte Isolationsschicht 64 in Form eines Siliziumnitridschutzes zwischen dem Material des ersten Leitfähigkeitsgebiets 30 und dem Halbleitersubstrat 20 vorgesehen wird.

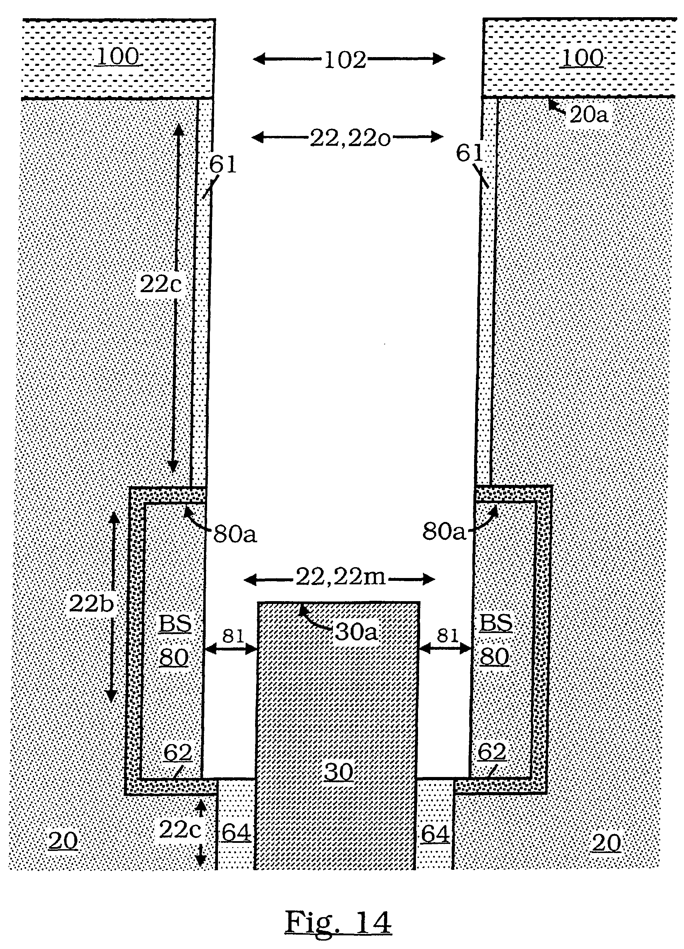

Fig. 14 zeigt darüber hinaus, dass nachfolgend die dritte Schutzschicht oder Isolationsschicht 63 vom epitaktisch aufgewachsenen Material 80 des Buried-Strap-Bereichs entfernt wurde, so dass nunmehr zwischen dem Material des ersten Leitfähigkeitsgebiets 30 und dem Material 80 des Buried-Strap-Bereichs BS oder Anschlussbereichs BS eine Lücke 81 ausgebildet ist.

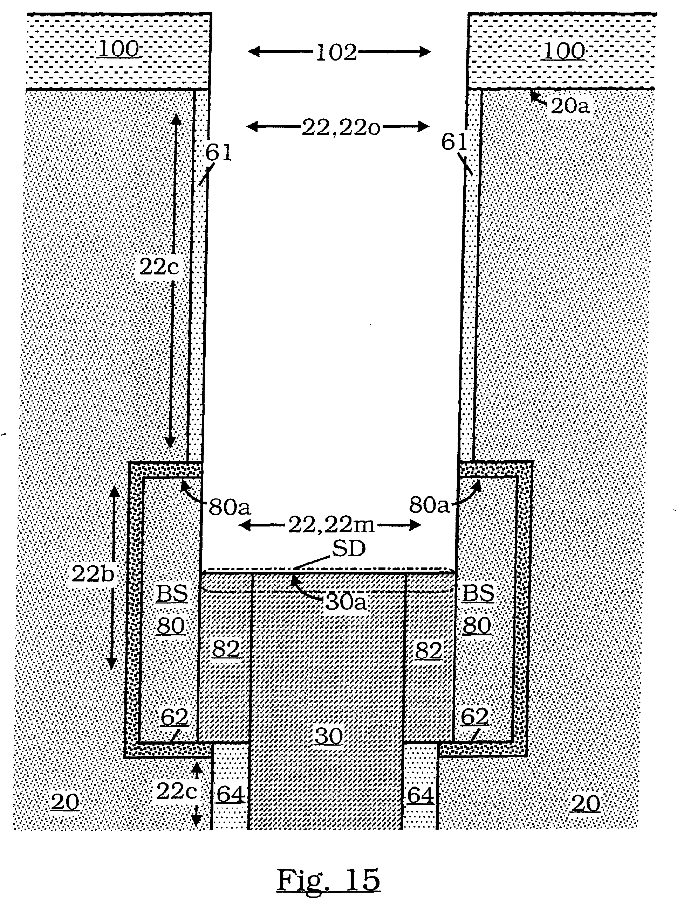

Im Übergang zu dem in Fig. 15 gezeigten Zwischenzustand ist diese Lücke 81 durch selektives Abscheiden, zum Beispiel durch Polysiliziumfüllung 82 und anschließendes Rückätzen, ausgefüllt, so dass der Bereich des Oberflächenbereichs 80a fernerhin das sogenannte Source-Draingebiet SD des auszubildenden vertikalen Feldeffekttransistors bildet und mit dem Buried-Strap-Gebiet oder Anschlussgebiet BS materiell und elektrisch leitend verbunden ist, wie das in Fig. 15 gezeigt ist.

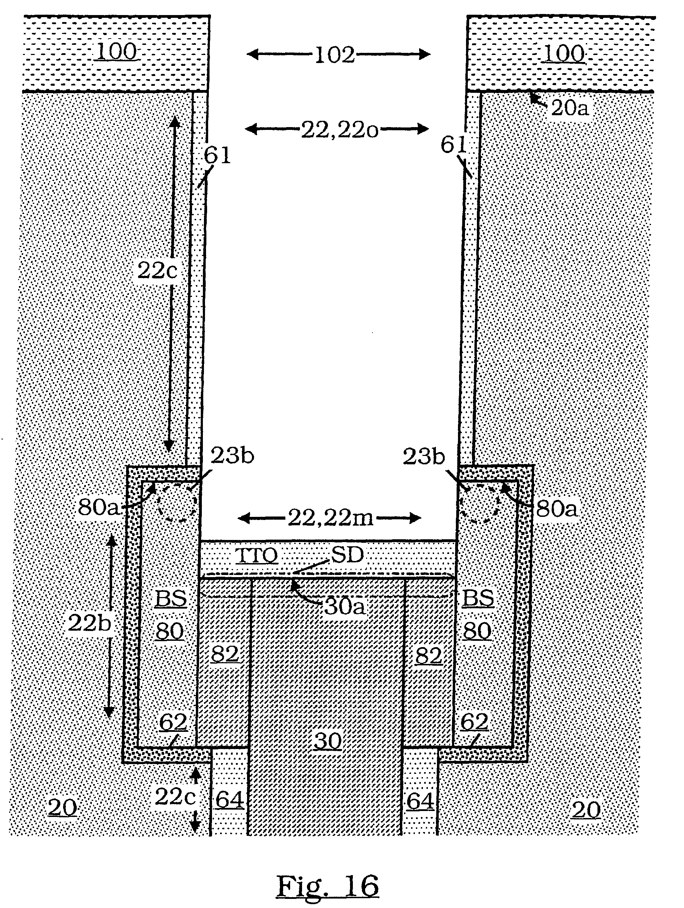

Im Übergang zum Zustand der Fig. 16 wird dann anisotrop das sogenannte Trench-Top-Oxid TTO abgeschieden, durch welches der Oberflächenbereich 30a des ersten Leitfähigkeitsgebiets und mithin das sogenannte Source-Draingebiet SD des auszubildenden vertikalen Feldeffekttransistors gegenüber dem darüberliegenden freien Lumen des ersten oder oberen Grabenabschnitts 22o der Ausnehmung 22 oder des Grabens 22 isoliert wird. Dabei bleibt, wie das in Fig. 16 gezeigt ist, ein oberer Bereich 23b des Materials 80 des Buried-Strap-Gebiets oder des Anschlussgebiets BS frei.

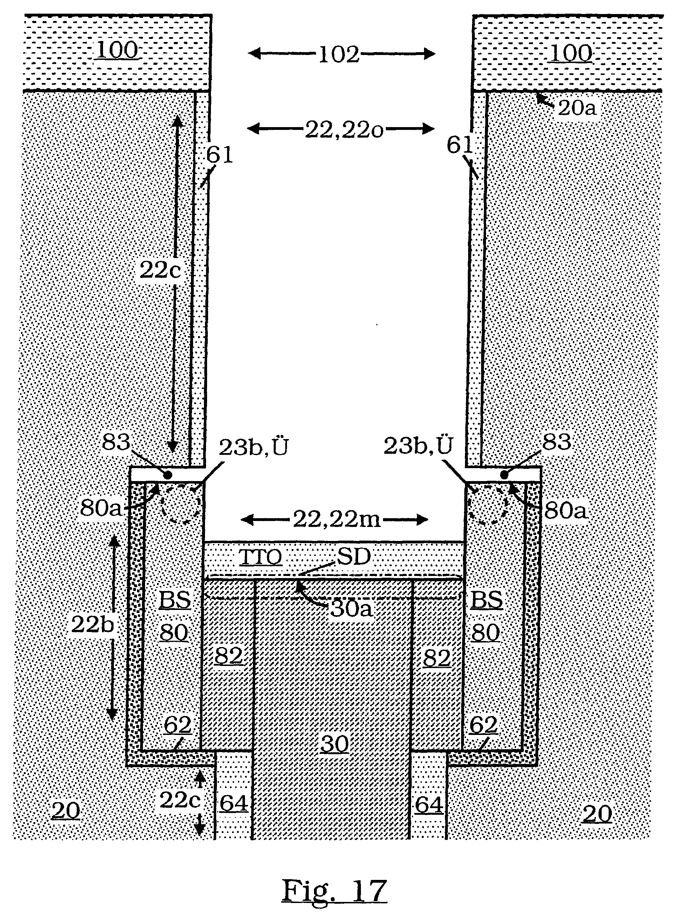

Nachfolgend wird dann, wie das in Fig. 17 gezeigt ist, ein isotroper Ätzvorgang ausgeführt. Durch diesen wird sowohl ein Teil des Trench-Top-Oxids TTO abgetragen. Vor allem aber wird an einem Oberflächenbereich 80a des Materials 80 des Anschlussgebietes BS das dort vorhandene Material des Isolationsbereichs 24 oder der zweiten Isolationsschutzschicht 62 lateral entfernt, so dass zwischen dem Oberflächenbereich 80a des Materials 80 des Anschlussgebiets BS und dem darüberliegenden Halbleitersubstrat 20 eine Lücke 83 ohne Zwischenschaltung eines isolierenden Materials entsteht.

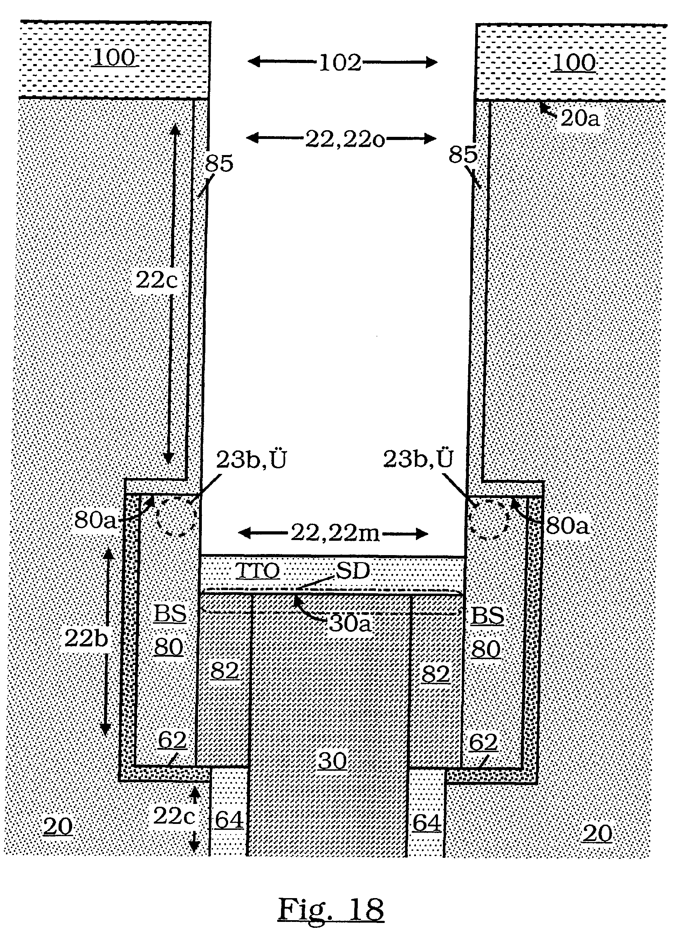

Im Übergang zum Zustand der Fig. 18 wird dann diese Lücke 83 durch ein leitfähiges Material 85 aufgefüllt, vorzugsweise durch selektives epitaktisches Aufwachsen einkristallinen Halbleitermaterials 85, wobei der Oberflächenbereich 80a des Materials 80 des Anschlussgebiets BS als Kernschicht dient.

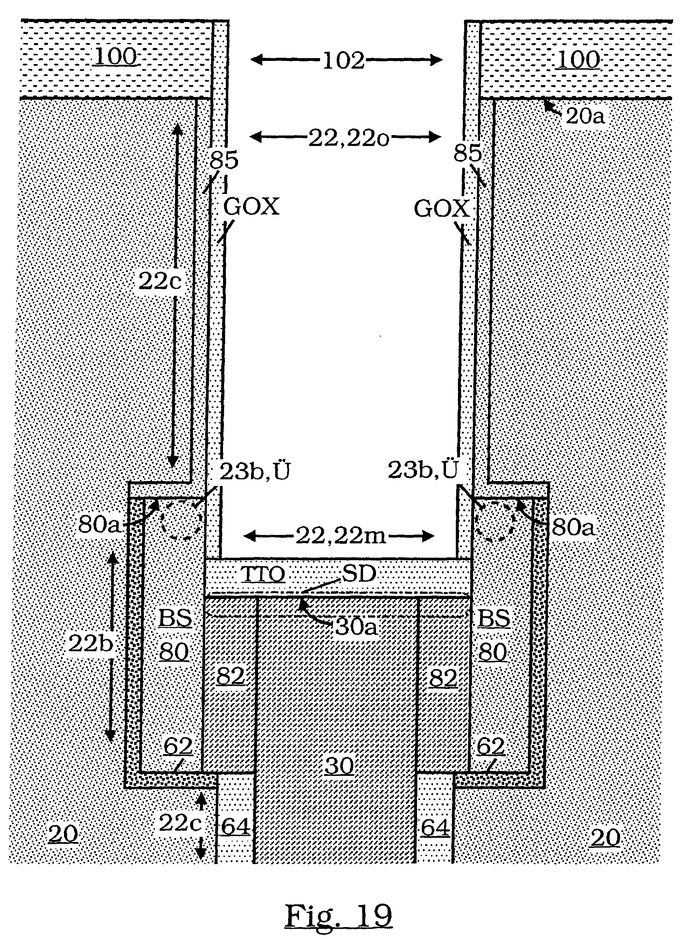

Nachfolgend wird dann in Wandbereichen und Randbereichen 22c und 22b, welche bis dahin freigeblieben sind, das sogenannte Gateoxid oder der Gateisolationsbereich GOX ausgebildet, so dass der obere Abschnitt 23b des Materials 80 des Anschlussgebiets BS den geforderten Überlappungsbereich Ü bildet, wie das in Fig. 19 gezeigt ist.

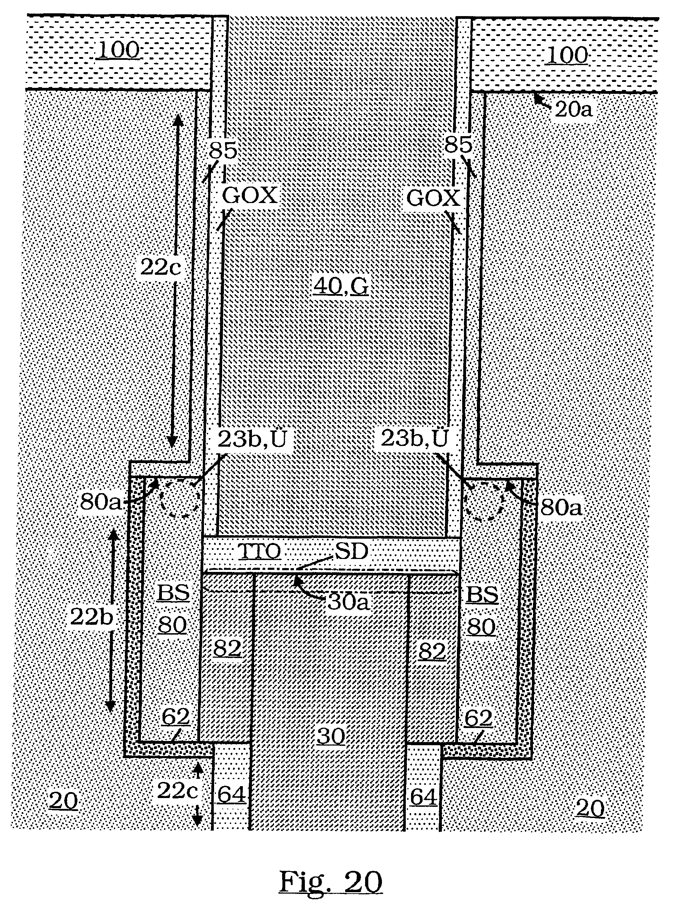

Im Übergang zum Zustand der Fig. 20 wird dann das freie Lumen des oberen Grabenabschnitts 20o mit einem zweiten Leitfähigkeitsgebiet 40 als Gatebereich G aufgefüllt.

### Bezugszeichenliste

- 10: Grabenstrukturtransistoreinrichtung, Deep-Trench-Transistor
- 20: Halbleitersubstrat, einkristallines p-dotiertes Bulksilizium
- 22: Ausnehmung, Graben
- 22m: mittlerer Grabenabschnitt
- 22o: oberer Grabenabschnitt
- 22u: unterer Grabenabschnitt
- 22a: unterer Wandbereich/Randbereich
- 22b: mittlerer Wandbereich/Randbereich
- 22c: oberer Wandbereich/Randbereich
- 23: Ausnehmung für Anschlussbereich BS
- 24: Isolationsgebiet, Diffusionsbarriere
- 30: erstes Leitfähigkeitsgebiet
- 40: zweites Leitfähigkeitsgebiet
- 30a: Oberflächenbereich
- 61: erste Schutzschicht/Isolationsschicht, Si₃N₄-Liner
- 62: zweite Schutzschicht/Isolationsschicht, Si₂O₃-Schicht
- 63: dritte Schutzschicht/Isolationsschicht, Si₂O₃-Schicht
- 64: vierte Schutzschicht/Isolationsschicht, Si₃N₄-Schicht
- 65: fünfte Schutzschicht/Isolationsschicht, Trench-Top-Oxid
- 66: sechste Isolationsschicht, Si₂O₃-Schicht
- 70: einkristalliner Keimbereich
- 80: selektiv epitaktisch aufgewachsenes einkristallines Material für BS
- 80a: Oberflächenbereich
- 81: Lücke
- 82: Polysiliziumfüllung
- 83: Lücke
- 85: selektiv epitaktisch aufgewachsenes einkristallines Material für SD
- 100: Maskenschicht
- 100a: Oberflächenbereich
- 102: Ausnehmung
- BS: Anschlussgebiet, Baried-Strap-Gebiet
- G: Gatebereich
- SD: Source-Drainbereich
- GOX: Gateisolationsbereich
- Ü: Überlappungsgebiet

## Patentansprüche

1. Verfahren zum Ausbilden einer Feldeffekttransistoreinrichtung in einem Halbleitersubstrat,
- bei welchem zum Anschließen der Feldeffekttransistoreinrichtung (10) an ein erstes vorzusehendes Leitfähigkeitsgebiet (30) des Halbleitersubstrats (20) ein Anschlussgebiet (BS) zu einem auszubildenden Source-Draingebiet (SD) der Feldeffekttransistoreinrichtung (10) vorgesehen wird und
- bei welchem zum Ausbilden einer potentiellen Source-Drain-Kanalstrecke (K) der Feldeffekttransistoreinrichtung (10) ein Überlappungsgebiet (Ü) des Source-Draingebiets (SD) und/oder des Anschlussgebiets (BS) mit einem auszubildenden Gateisolationsbereich (GOX) vorgesehen wird,
**dadurch gekennzeichnet,**
**dass** das Überlappungsgebiet (Ü) direkt als materieller Bereich ausgebildet wird, insbesondere unter weitestgehender Vermeidung von Ausdiffusionsvorgängen.

2. Verfahren nach Anspruch 1,
**dadurch gekennzeichnet,**
**dass** das Anschlussgebiet (BS) und das Überlappungsgebiet (Ü) im Wesentlichen aus demselben Material ausgebildet werden.

3. Verfahren nach einem der vorangehenden Ansprüche,
**dadurch gekennzeichnet,**
**dass** das Anschlussgebiet (BS) und das Überlappungsgebiet (Ü) einteilig oder einstückig ausgebildet werden.

4. Verfahren nach einem der vorangehenden Ansprüche,
**dadurch gekennzeichnet,**
**dass** das Anschlussgebiet (BS) und/oder das Überlappungsgebiet (Ü) epitaktisch aufgewachsen und/oder einkristallin ausgebildet werden, insbesondere als selektives epitaktisches einkristallines dotiertes Silizium oder dergleichen.

5. Verfahren nach einem der vorangehenden Ansprüche,
**dadurch gekennzeichnet,**
**dass** zur Vermeidung oder Unterdrückung von Ausdiffusionsvorgängen aus dem Anschlussgebiet (BS) und/oder dem Überlappungsgebiet (Ü) und/oder zur Vermeidung oder Unterdrückung von nicht gewünschten elektrischen Kontakten des Anschlussgebietes (BS) und/oder des Überlappungsgebiets (Ü) mit weiteren Gebieten das Anschlussgebiet (BS) und/oder das Überlappungsgebiet (Ü) zumindest teilweise in ein Isolationsgebiet (24) eingebettet und/oder eingeschlossen werden.

6. Verfahren nach einem der vorangehenden Ansprüche,
**dadurch gekennzeichnet,**
**dass** das Anschlussgebiet (BS) und/oder das Überlappungsgebiet (Ü) und/oder Teile davon als Buried-Plate-Struktur (BS) ausgebildet werden, insbesondere in vergrabener Form.

7. Verfahren nach einem der vorangehenden Ansprüche,
**dadurch gekennzeichnet,**
**dass** die Feldeffekttransistoreinrichtung (10) als Grabenstrukturtransistoreinrichtung (10) ausgebildet wird, insbesondere als Deep-Trench-Transistor oder dergleichen und/oder insbesondere zum Anschließen an und/oder für eine DRAM-Speicherzelle oder dergleichen.

8. Verfahren nach Anspruch 7,
**dadurch gekennzeichnet,**
**dass** im Halbleitersubstrat (20) jeweils eine Ausnehmung oder ein Graben (22) ausgebildet wird.

9. Verfahren nach Anspruch 8,
**dadurch gekennzeichnet,**
**dass** in einem oberen Grabenabschnitt (220) mit oberen Randbereichen oder Wandbereichen (22c) die, insbesondere vertikal ausgerichtete, Grabenstrukturtransistoreinrichtung (10) mit einem gegenüber den oberen Wandbereichen oder Randbereichen (32c) und gegenüber einem vorgesehenen mittleren Grabenabschnitt (22m) im Wesentlichen elektrisch isolierten Gatebereichen (G) ausgebildet wird.

10. Verfahren nach Anspruch 9,
**dadurch gekennzeichnet,**
**dass** im Wesentlichen unmittelbar räumlich anschließend an den isolierten Gatebereich (G), insbesondere unterhalb davon, der Source-Drain-Bereich (SD) sowie das Anschlussgebiet (BS) im Bereich des mittleren Grabenabschnitts (22m) vorgesehen werden.

11. Verfahren nach Anspruch 10,
**dadurch gekennzeichnet,**
**dass** in im Wesentlichen elektrisch leitendem Kontakt zumindest mit dem Anschlussgebiet (BS) das zu kontaktierende erste Leitfähigkeitsgebiet (30) im Wesentlichen zumindest im unteren Grabenabschnitt (22u) vorgesehen wird.

12. Verfahren nach einem der Ansprüche 7 bis 11,
**dadurch gekennzeichnet,**
**dass** zunächst ein Maskenbereich (100) auf einem Oberflächenbereich (20a) des Halbleitersubstrats (20), gegebenenfalls mehrschichtig ausgebildet, abgeschieden und gemäß einer gewünschten auszubildenden Grabenstruktur mit Ausnehmungen (102) strukturiert wird.

13. Verfahren nach einem der Ansprüche 7 bis 12,
**dadurch gekennzeichnet,**
**dass** als Halbleitersubstrat (20) ein einkristallines Halbleitermaterial verwendet wird, insbesondere einkristallines Silizium, gegebenenfalls p-dotiert, und/oder dergleichen.

14. Verfahren nach einem der Ansprüche 7 bis 13,
**dadurch gekennzeichnet,**
**dass** die jeweilige Ausnehmung oder der jeweilige Graben (22) in mehreren zeitlich voneinander getrennten oder unterbrochenen Prozessabschnitten strukturiert wird.

15. Verfahren nach einem der Ansprüche 7 bis 14,
**dadurch gekennzeichnet**,
das zunächst der obere Grabenabschnitt (20o) mit oberen Randbereichen (22c) oder Wandbereichen (22c) in das Halbleitersubstrat (20) geätzt wird, insbesondere für die vertikale Grabenstrukturtransistoreinrichtung (10) und/oder insbesondere mit einer Tiefe im Bereich von 1 um, wobei ein erster temporärer Bodenbereich (20a') ausgebildet wird.

16. Verfahren nach Anspruch 15,
**dadurch gekennzeichnet,**
**dass** dann der obere Grabenabschnitt (22o), insbesondere lateral, aufgeweitet wird, vorzugsweise durch einen isotropen Rückätzschritt und/oder insbesondere durch ein Silizium-Pull-Back-Verfahren, vorzugsweise im Bereich einer Schichtdicke von ca. 5 nm.

17. Verfahren nach einem der Ansprüche 15 oder 16,
**dadurch gekennzeichnet,**
**dass** eine erste Schutzschicht (61) abgeschieden wird, insbesondere in konformaler Art und Weise und/oder mit einer Schichtstärke im Bereich von ca. 5 nm, vorzugsweise als Si₃N₄-Liner oder dergleichen.

18. Verfahren nach Anspruch 17,
**dadurch gekennzeichnet,**
**dass** durch, insbesondere anisotropes, Ätzen unter Durchbrechung der ersten Schutzschicht (61) am ersten temporären Bodenbereich (20a'), der zweite, mittlere Grabenabschnitt (22m) mit mittleren Wandbereichen oder Randbereichen (22b), insbesondere für den Anschlussbereich (BS), vorzugsweise mit einer Tiefe im Bereich von ca. 200 - 300 nm ausgebildet wird, wobei ein zweiter temporärer Bodenbereich (22a") ausgebildet wird.

19. Verfahren nach Anspruch 18,
**dadurch gekennzeichnet,**
**dass** der mittlere Grabenabschnitt (22m), insbesondere lateral, aufgeweitet wird, vorzugsweise durch einen isotropen Rückätzschritt und/oder insbesondere durch ein Silizium-Pull-Back-Verfahren, vorzugsweise im Bereich einer Schichtdicke von ca. 20 - 40 nm, wobei dadurch Ausnehmungen (23) insbesondere für den vorzusehenden Anschlussbereich (BS), im Bereich der mittleren Wandbereiche (22b) oder Randbereiche (22b) geschaffen werden.

20. Verfahren nach Anspruch 19,
**dadurch gekennzeichnet,**
**dass** zum Ausbilden des Isolationsgebiets (24) eine zweite Schutzschicht oder Isolationsschicht (62) ausgebildet wird, insbesondere in konformer Art und Weise, mit einer Schichtdicke im Bereich von ca. 10 nm und/oder unter Verwendung von Siliziumdioxid SiO₂, oxidiertem Siliziumnitrid Si₃N₄ und/oder dergleichen.

21. Verfahren nach einem der vorangehenden Ansprüche,
**dadurch gekennzeichnet,**
**dass** zum Ausbilden des Anschlussgebiets (BS), des Source-/Draingebiets (SD) und/oder des Überlappungsgebiets (Ü), insbesondere als einkristalline epitaktische Halbleitermaterialbereiche, ein einkristalliner Keimbereich (70) ausgebildet wird.

22. Verfahren nach Anspruch 21,
**dadurch gekennzeichnet,**
**dass** der einkristalline Keimbereich (70) ausgebildet wird, durch, insbesondere anisotropes, Ätzen unter Durchbrechung der zweiten Schutzschicht oder Isolationsschicht (62) am zweiten temporären Bodenbereich (22a") des zweiten, mittleren Grabenabschnitts (22m), wobei am zweiten temporären Bodenbereich (22a") zugrundeliegendes einkristallines Halbleitersubstrat freigelegt wird, wobei gegebenenfalls der zweite temporäre Bodenbereich (22a") durch Ätzen leicht ausgenommen wird.

23. Verfahren nach Anspruch 22,
**dadurch gekennzeichnet,**
**dass** auf dem einkristallinen Keimbereich (70) selektiv epitaktisch einkristallines Halbleitermaterial (80) derart aufgewachsen wird, dass der mittlere Grabenabschnitt (22m) vollständig gefüllt wird, insbesondere bis leicht über das Niveau des ersten temporären Bodenbereichs (20a') hinaus, wobei gegebenenfalls eine vorliegende Dotierstoffkonzentration eingebracht wird, insbesondere in Form eines Konzentrationsgradienten, und wobei insbesondere die seitlichen Ausnehmungen (23) für den Anschlussbereich (BS) in den mittleren Wandbereichen (22b) oder Randbereichen (22b) vollständig gefüllt werden.

24. Verfahren nach Anspruch 23,
**dadurch gekennzeichnet,**
**dass** der mittlere Grabenabschnitt (22m) vertikal wieder geöffnet wird, und zwar bis leicht unter das Niveau des zweiten temporären Bodenbereichs (22a"), insbesondere durch, insbesondere anisotropes, Ätzen, wobei insbesondere Material der zweiten Schutzschicht (62) im Bereich der oberen Randbereiche oder Wandbereiche (22c) entfernt wird.

25. Verfahren nach Anspruch 24,
**dadurch gekennzeichnet,**
**dass** eine dritte Schutzschicht oder Isolationsschicht (63) ausgebildet wird, so dass der zweite temporäre Bodenbereich (22a") und im Bereich der mittleren Randbereiche oder Wandbereiche (22b) das selektiv epitaktisch aufgewachsene einkristalline Material (80) in den Ausnehmungen (23) für den Anschlussbereich (BS), den Source-Drain-Bereich (SD) und/oder den Überlappungsbereich (Ü) abgedeckt wird, so dass das selektiv epitaktisch aufgewachsene einkristalline Material (80) in den Ausnehmungen (23) den Anschlussbereich (BS), den Source-Drain-Bereich (SD) und/oder den Überlappungsbereich (Ü) oder zumindest Teile davon bilden.

26. Verfahren nach Anspruch 25,
**dadurch gekennzeichnet,**
**dass** die dritte Schutzschicht oder Isolationsschicht (63) durch selektives elektrochemisches Abscheiden und/oder Umwandeln erzeugt wird, insbesondere durch Oxidation eines Siliziummaterials oder dergleichen.

27. Verfahren nach einem der Ansprüche 25 oder 26,
**dadurch gekennzeichnet,**
- **dass** durch anisotropes Ätzen der dritte, untere Grabenabschnitt (22u), insbesondere für das erste Leitfähigkeitsgebiet (30) ausgebildet wird, und
- **dass** der erste Leitfähigkeitsbereich (30) ausgebildet wird, vorzugsweise durch Füllen des unteren Grabenabschnitts (22u) bis zu einem Niveau unterhalb des ersten temporären Bodenbereichs (22a'), vorzugsweise durch Füllen des Grabens (22) mit Polysilizium oder dergleichen und entsprechendes anisotropes Rückätzen, wobei gegebenenfalls eine vierte Schutzschicht (64) zwischen dem Halbleitersubstrat (20) und dem ersten Leitfähigkeitsbereich (30) vorgesehen wird, insbesondere in Form von Siliziumnitrid oder dergleichen.

28. Verfahren nach Anspruch 27,
**dadurch gekennzeichnet,**
**dass** spezifisch das Material der dritten Schutzschicht oder Isolationsschicht (63), insbesondere die das selektiv epitaktisch aufgewachsene einkristalline Material (80) in den Ausnehmungen (23) für den Anschlussbereich (BS), also der den Anschlussbereich (BS) oder Buried-Strapbereich abdeckende Bereich davon, entfernt wird, insbesondere durch spezifisches Ätzen.

29. Verfahren nach Anspruch 28,
**dadurch gekennzeichnet,**
**dass** das erste Leitfähigkeitsgebiet (30) mit dem Anschlussgebiet (BS) oder dem Buried-Strap-Gebiet (BS) elektrisch kontaktiert wird, insbesondere durch Auffüllen mit Polysilizium und/oder durch selektives epitaktisches Aufwachsen und Verschließen von Lücken zwischen dem ersten Leitfähigkeitsgebiet (30) und dem Material des Anschlussgebiets (BS) oder des Buried-Strap-Gebiets, wobei ein Teil (22b') der mittleren Wandbereiche oder Randbereiche (22b) des Grabens (22), also des Anschlussgebietes (BS) oder des Buried-Strap-Gebiets (BS) unbedeckt bleiben.

30. Verfahren nach Anspruch 29,
**dadurch gekennzeichnet,**
**dass** der Oberflächenbereich (30a) des ersten Leitfähigkeitsgebiets (30) mit einer fünften Schutzschicht oder Isolationsschicht (65), insbesondere aus Siliziumdioxid (SiO₂), abgedeckt wird, wobei zumindest ein Teil (22b") der mittleren Wandbereiche oder Randbereiche (22b) des Grabens (22), also des Anschlussgebiets (BS) oder des Buried-Strap-Gebiets (BS) frei und unbedeckt bleiben.

31. Verfahren nach Anspruch 30,
**dadurch gekennzeichnet,**
**dass** durch, insbesondere isotropes, Ätzen zumindest im Bereich des Übergangs zwischen dem mittleren Grabenabschnitt (22m) und dem oberen Grabenabschnitt (22o) und insbesondere in den Ausnehmungen (23) für das Anschlussgebiet (BS), das Source-Draingebiet (SD) und/oder das Überlappungsgebiet (Ü) bestehende Isolationsschichten oder Schutzschichten (62) zwischen dem Anschlussgebiet (BS), dem Source-Draingebiet (SD) und/oder dem Überlappungsgebiet (Ü) und dem Halbleitersubstrat (20) entfernt werden, wobei insbesondere eine sich im Wesentlichen lateral erstreckende Ausnehmung (23') geschaffen wird im oberen Bereich (BSa) des Anschlussgebiets (BS).

32. Verfahren nach Anspruch 31,
**dadurch gekennzeichnet,**
**dass** durch Füllen der Ausnehmung (23) im oberen Bereich (BSa) des Anschlussgebiets (BS) mit einem elektrisch leitfähigen Material ein Anschluss ausgebildet wird zwischen dem ersten Leitfähigkeitsgebiet (30) und zumindest dem Anschlussgebiet (BS).

33. Verfahren nach Anspruch 32,
**dadurch gekennzeichnet,**
**dass** das Füllen der Ausnehmungen (23) im oberen Bereich (BSa) des Anschlussgebiets (BS) durch selektives epitaktisches Aufwachsen und/oder durch einen Wasserstoff-Reflowprozess erfolgt.

34. Verfahren nach Anspruch 32,
**dadurch gekennzeichnet,**
**dass** zur Ausbildung des Gatebereichs (G) der Grabenstrukturtransistoreinrichtung (10) zunächst eine sechste Isolationsschicht oder Schutzschicht (66) als Gateisolationsbereich (GOX) abgeschieden wird an den freibleibenden Bereichen der oberen und mittleren Randbereiche oder Wandbereiche (22b, 22c) und dass dann das freibleibende Lumen des Grabens (22) mit einem zweiten Leitfähigkeitsgebiet (G) als Gatekontakte (G) gefüllt wird.
